# EUROPÄISCHE PATENTSCHRIFT

(11) **EP 0 663 692 B1**
(45) Veröffentlichungstag und Bekanntmachung des Hinweises auf die Patenterteilung: **23.02.2000**
(21) Anmeldenummer: 94120791.2
(22) Anmeldetag: 27.12.1994
(51) Int. Cl.: H01L 23/00, G01L 21/00

(54) **Verfahren zur Herstellung einer Schicht mit reduzierten mechanischen Spannungen**
Process for fabricating a layer having reduced strain
Procédé de fabrication d'une couche à contraintes mécaniques réduites

(30) Priorität: 04.01.1994 DE 4400119
(43) Veröffentlichungstag der Anmeldung: 19.07.1995
(73) Patentinhaber: SIEMENS AKTIENGESELLSCHAFT, 80333 München (DE)
(72) Erfinder: Biebl, Markus, D-86163 Augsburg (DE)

(56) Entgegenhaltungen:
- EP-A- 0 497 499
- EP-A- 0 574 697
- US-A- 4 998 267
- US-A- 5 059 556
- PATENT ABSTRACTS OF JAPAN vol. 12, no. 395 (E-671), 20.Oktober 1988 & JP 63 136521 A (SHARP CORP), 8.Juni 1988,
- PATENT ABSTRACTS OF JAPAN vol. 17, no. 453 (E-1417), 19.August 1993 & JP 05 102326 A (NEC CORP), 23.April 1993,
- Mat. Res. Soc. Symp. Proc., Bd 284, 1993, Seiten 119-125

## Beschreibung

Bei der Herstellung von Schichten in der Halbleitertechnologie kommt es vielfach zur Ausbildung von mechanischen Spannungen innerhalb der Schichten. Diese mechanischen Spannungen sind abhängig von den gewählten Abscheidebedingungen. Diese mechanischen Spannungen werden vielfach als Streß bezeichnet. Man unterscheidet zwischen dem absoluten Streß, der die integrale mechanische Verspannung einer Schicht bezeichnet und dem Streßgradienten, der mechanische Verspannungen innerhalb der Schicht beschreibt und zu einem Biegemoment führt.

Derartige mechanische Spannungen werden insbesondere bei der Herstellung von Schichten aus Polysilizium, SiO₂, Si₃N₄ und Metall beobachtet.

Mechanische Spannungen beeinflussen Diffusionsprozesse innerhalb einer Schicht. Bei der Verwendung von dotierten Schichten, zum Beispiel aus Polysilizium, als Diffusionsquelle, machen sich daher mechanische Spannungen der Polysiliziumschicht störend bemerkbar.

In der Mikromechanik werden durch Strukturierung und teilweises Unterätzen von Schichten freitragende Strukturen erzeugt, die über Stützstellen mit einem Substrat verbunden sind. Mikromechanik auf der Basis von Siliziumprozeßtechnik gewinnt in der Sensorik zunehmend an Bedeutung, da hier mikromechanische Systeme mit einer Auswerteelektronik integriert auf einem Substrat herstellbar sind. Bei der Herstellung freitragender Strukturen macht sich ebenfalls eine mechanische Spannung in der Schicht, aus der die Strukturen hergestellt werden, störend bemerkbar. Der absolute Streß kann in diesen Systemen zwar durch eine geeignete streßrelaxierende Aufhängung der Strukturen kompensiert werden, der Streßgradient führt jedoch zu einer Verbiegung der freitragenden Struktur, die diese unbrauchbar macht.

Zur Reduktion von mechanischen Spannungen in einer Schicht ist es bekannt (siehe zum Beispiel H. Guckel et al., Sensors and Actuators, 20 (1989), 117 - 122 "Fabrication of Micromechanical Devices from Polysilicon Films with Smooth Surfaces"), die Schicht zu dotieren und anschließend zu tempern. Zur wirksamen Beseitigung der Spannungen sind allerdings Temperaturbudgets erforderlich, die wesentlich über die für moderne Elektronikprozesse tragbaren Temperaturbelastungen hinausgehen. Daher ist dieses Verfahren für den Einsatz in der Mikroelektronik nicht geeignet.

Aus Mat. Res. Soc. Symp. Proc., Vol. 284, 1993, Seiten 119 bis 125, ist bekannt, in Doppelschichten aus SiO₂ und Si₃N₄ mit Druck- bzw. Zugspannung den internen Streß durch Variation des Dickenverhältnisses zu kompensieren.

Aus US-A-4 998 267 ist bekannt, zur Vermeidung von Verwindungen in Röntgenlithographiemasken auf Kohlenstoffbasis eine Vielfachschichtstruktur zu bilden, die eine erste Schicht aus Kohlenstoff mit interner kompressiver Streßcharakteristik und eine zweite Schicht aus anorganischem Material mit interner tensiler Streßcharakteristik aufzubauen. Die unterschiedlichen Streßcharakteristiken kompensieren sich in der Vielfachschicht.

Aus EP 0 574 697 A1 ist ein Sensor bekannt, der eine an zwei Stützstellen befestigte Schicht mit tensiler Spannung aufweist. Die Schicht mit tensiler Spannung umfaßt eine Siliziumnitridschicht, die zwischen zwei Polysiliziumschichten eingelagert ist. Dabei bestimmt die Siliziumnitridschicht die mechanische Spannung der gesamten Schicht.

Der Erfindung liegt das Problem zugrunde, ein Verfahren zur Herstellung einer Schicht mit reduzierten mechanischen Spannungen anzugeben, bei dem untragbare Temperaturbelastungen vermieden werden.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird die Schicht aus mindestens einer ersten Teilschicht und einer zweiten Teilschicht zusammengesetzt. Dabei sind die erste Teilschicht und die zweite Teilschicht so aufeinander abgestimmt, daß sich die Streßgradienten in beiden Schichten im wesentlichen kompensieren. Zwischen zwei benachbarten Teilschichten wird eine Hilfsschicht erzeugt, die dünner als die Teilschichten ist. Dadurch heben sich die Biegemomente der Teilschichten auf. Eine Verbiegung einer freitragenden Struktur, die aus dieser Schicht später gebildet wird, wird dadurch vermieden. Dieses erfolgt zum Beispiel dadurch, daß die erste Teilschicht unter Zugspannung und die zweite Teilschicht unter einer entsprechenden Druckspannung abgeschieden werden. Für das erfindungsgemäße Verfahren ist es wesentlich, daß durch entsprechende Streßgradienten in den beiden Teilschichten das resultierende Kraftmoment in der Mittelebene der hergestellten Schicht Null wird.

Zur Herstellung einer Schicht aus Polysilizium ist es vorteilhaft, die erste Teilschicht aus Polysilizium und die zweite Teilschicht aus amorphem Silizium zu bilden. Zwischen der ersten Teilschicht und der zweiten Teilschicht wird eine Hilfsschicht aus zum Beispiel SiO₂ erzeugt, um ein epitaktisches Aufwachsen der amorphen Schicht zu vermeiden. Durch anschließendes Tempern der beiden Teilschichten entsteht aus der zweiten Teilschicht aus amorphem Silizium polykristallines Silizium. Die dafür erforderlichen Temperaturbelastungen sind mit mikroelektronischen Herstellprozessen verträglich.

Es liegt insbesondere im Rahmen der Erfindung, die Schicht aus mehr als zwei Teilschichten zusammenzusetzen. In diesem Fall kommt es zu einer Mittelung des Gradienten der mechanischen Spannungen. Erfindungsgemäß werden die Teilschichten so aufeinander abgestimmt, daß das resultierende Kraftmoment in der Mittelebene der hergestellten Schicht Null ist.

Eine nach dem erfindungsgemäßen Verfahren hergestellte Schicht ist insbesondere geeignet als Diffusionsquelle. Weiterhin ist sie als Ausgangspunkt für die Herstellung eines mikromechanischen Systems geeignet.

Im folgenden wird die Erfindung anhand der Figuren und der Ausführungsbeispiele näher erläutert.
- Figur 1: zeigt eine aus vier Teilschichten zusammengesetzte Schicht, wobei zwischen je zwei benachbarten Teilschichten eine Hilfsschicht angeordnet ist.
- Figur 2 und Figur 3: zeigt die Herstellung einer mikromechanischen Struktur aus der aus vier Teilschichten zusammengesetzten Schicht.

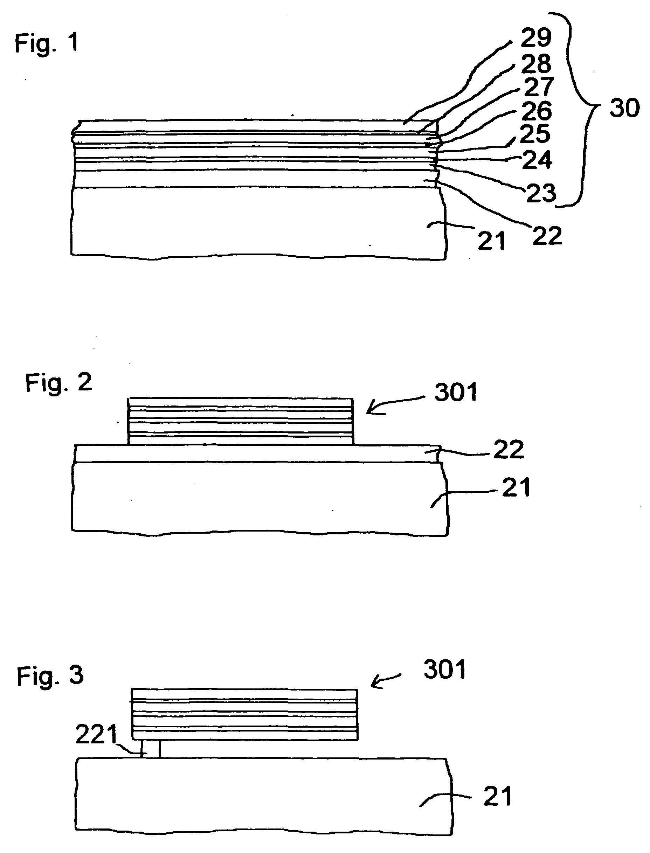

Auf ein Substrat 21 wird eine Opferschicht 22 aufgebracht (siehe Figur 1). Das Substrat 21 ist zum Beispiel ein Silizium-Wafer oder ein SOI-Substrat. Die Opferschicht 22 wird zum Beispiel aus SiO₂ in einer Dicke von zum Beispiel 1 µm aufgebracht.

Auf die Opferschicht 22 wird eine erste Teilschicht 23 aufgebracht. Auf die erste Teilschicht 23 wird eine Hilfsschicht 24 aufgebracht. Auf die Hilfsschicht 24 wird eine zweite Teilschicht 25 aufgebracht. Auf die zweite Teilschicht 25 wird eine Hilfsschicht 26 aufgebracht. Auf die Hilfsschicht 26 wird eine dritte Teilschicht 27 aufgebracht. Auf die dritte Teilschicht 27 wird eine Hilfsschicht 28 aufgebracht. Auf die Hilfsschicht 28 wird eine vierte Teilschicht 29 aufgebracht. Die erste Teilschicht 23, die Hilfsschicht 24, die zweite Teilschicht 25, die Hilfsschicht 26, die dritte Teilschicht 27, die Hilfsschicht 28 und die vierte Teilschicht 29 bilden zusammen eine Schicht 30 mit reduzierten mechanischen Spannungen.

Die erste Teilschicht 23 wird zum Beispiel aus polykristallinem Silizium auf die Opferschicht 22 aufgebracht. Anschließend wird die Hilfsschicht 24 aus SiO₂ in einer Dicke von zum Beispiel 0,1 bis 3 nm erzeugt. Die Hilfsschicht 24 wird zum Beispiel durch eine entsprechende Wartezeit an Atmosphäre, eine oxidierende Reinigung oder durch Oxidation bei erhöhter Temperatur erzeugt. Die zweite Teilschicht 25 wird ebenfalls aus polykristallinem Silizium erzeugt. Da die Hilfsschicht 24 für die Keimbildung und das Wachstum der zweiten Teilschicht 25 entsprechende Voraussetzungen wie die Opferschicht 22 bietet, wächst die zweite Teilschicht 25 analog zu der ersten Teilschicht 23 auf. Der Streßgradient in der zweiten Teilschicht 25 entspricht daher demjenigen in der ersten Teilschicht 23.

Die Hilfsschicht 26 wird ebenfalls in einer Dicke von etwa 0,1 bis 3 nm aus SiO₂ erzeugt. Darauf wird die dritte Teilschicht 27 ebenfalls aus polykristallinem Silizium abgeschieden, wobei das Wachstum der dritten Teilschicht 27 demjenigen der zweiten Teilschicht 25 sowie der ersten Teilschicht 23 entspricht. Auf die dritte Teilschicht 27 wird die Hilfsschicht 28 aus SiO₂ in einer Dicke zwischen 0,1 und 3 nm aufgebracht. Auf die Hilfsschicht 28 wird die vierte Teilschicht 29 ebenfalls aus polykristallinem Silizium aufgewachsen.

Da die erste Teilschicht 23, die zweite Teilschicht 25, die dritte Teilschicht 27 und die vierte Teilschicht 29 unter vergleichbaren Bedingungen aufgewachsen worden sind, sind die Streßgradienten in allen Teilschichten gleich.

Beim Aufwachsen von einer Schicht aus Polysilizium kommt es im unteren Teil zu einem Wachstum vieler kleiner Kristallite, die im Laufe der Schichtabscheidung um das weitere Wachstum konkurrieren. Das führt in einer polykristallinen Siliziumschicht, die eine Dicke von zum Beispiel 200 bis 2000 nm aufweist, zu einem starken Druckstreß in den ersten etwa 100 nm. Nach oben hin nimmt der Druckstreß ab.

Dieser Streßgradient in jeder der Teilschichten 23, 25, 27, 29 wird in dem erfindungsgemäßen Verfahren kompensiert, da die übereinander abgeschiedenen Teilschichten zu einer Mittelung des Streßgradienten führen. Je mehr Teilschichten unter entsprechenden Bedingungen aus Polysilizium abgeschieden werden, desto besser wird die mechanische Spannung der einzelnen Teilschichten in der Schicht 30 kompensiert.

In einem anderen Ausführungsbeispiel der Erfindung werden die erste Teilschicht 23 und die dritte Teilschicht 27 aus polykristallinem Silizium abgeschieden. Die zweite Teilschicht 25 und die vierte Teilschicht 29 wird dagegen aus amorphem Silizium abgeschieden. Die Hilfsschichten 24, 26, 28 werden wiederum aus SiO₂ in einer Dicke zwischen 0,1 und 3 nm abgeschieden. Bei der Abscheidung von polykristallinem Silizium ergibt sich in der Schicht ein Druckstreß. Bei der Abscheidung von amorphem Silizium dagegen ergibt sich in der entstehenden Schicht ein Zugstreß. Die Hilfsschichten 24, 26, 28 stellen sicher, daß beim Aufwachsen von Silizium kein epitaktisches Wachstum einsetzt. Durch eine Temperung der Schicht 30 werden die zweite Teilschicht 25 und die vierte Teilschicht 29 aus amorphem Silizium in polykristallines Silizium umgewandelt.

Zur Einstellung des elektrischen Widerstands der Schicht 30 wird Dotierstoff in die Teilschichten 23, 25, 27, 29 eingebracht. Dieses kann sowohl jeweils nach der Abscheidung der entsprechenden Teilschicht als auch nach Fertigstellung der Gesamtschicht 30 erfolgen. Damit die Schicht 30 einen Schichtwiderstand entsprechend einer einzigen gleich dicken Polysiliziumschicht aufweist, ist es vorteilhaft, die Hilfsschichten 24, 26, 28 aus SiO₂ durch eine Temperung aufzubrechen. Eine solche Temperung ist zum Beispiel eine ROA-Temperung bei etwa 1000°C. Eine solche Temperung ist prozeßkompatibel.

Die Schicht 30 ist zur Herstellung einer freitragenden Struktur in einem mikromechanischen System geeignet. Dazu wird die Schicht 30 strukturiert, so daß eine freitragende Struktur 301 entsteht. Dieses erfolgt mit Hilfe einer Maskentechnik und einer zur Opferschicht 22 selektiven Ätzung (siehe Figur 2). Anschließend wird die Opferschicht 22 in einem isotropen Ätzprozeß zum Beispiel mit gepufferter Flußsäure, der zur freitragenden Struktur 301 und zum Substrat 21 selektiv erfolgt, teilweise entfernt, so daß von der Opferschicht 22 nur eine Stützstelle 221 stehen bleibt, über die die freitragende Struktur 301 mit dem Substrat 21 verbunden ist (siehe Figur 3). In dem Substrat 21 können vor oder nach der Herstellung der freitragenden Struktur 301 Komponenten für eine Ansteuerelektronik des mikromechanischen Systems realisiert werden.

Die erste Teilschicht 23, die zweite Teilschicht 25, die dritte Teilschicht 27 und die vierte Teilschicht 29 werden vorzugsweise in einer Dicke zwischen 50 nm und 1 µm erzeugt.

## Patentansprüche

1. Verfahren zur Herstellung einer Schicht mit reduzierten mechanischen Spannungen,
- bei dem die Schicht (30) aus mindestens einer ersten Teilschicht (23) und einer zweiten Teilschicht (25) zusammengesetzt wird,
- bei dem die erste Teilschicht (23) auf ein Substrat (21, 22) aufgebracht wird,
- bei dem die zweite Teilschicht (25) auf die erste Teilschicht (23) aufgebracht wird,
- bei dem die erste Teilschicht (23) und die zweite Teilschicht (25) so aufeinander abgestimmt werden, daß der Streßgradient der ersten Teilschicht (23) und der Streßgradient der zweiten Teilschicht (25) sich im wesentlichen kompensieren,
- bei dem zwischen zwei benachbarten Teilschichten (23, 25) eine Hilfsschicht (24) erzeugt wird, die dünner als die Teilschichten (23, 25) ist,
- bei dem die erste Teilschicht (23) und die zweite Teilschicht (25) aus polykristallinem oder amorphen Silizium erzeugt werden,
- bei dem die erste Teilschicht (23) und die zweite Teilschicht (25) durch Implantation dotiert werden,
- bei dem die erste Teilschicht (23) und die zweite Teilschicht (25) in einem Temperschritt ausgeheilt werden,
- bei dem die Hilfsschicht (24) aus SiO₂ gebildet wird.

2. Verfahren nach Anspruch 1,
bei dem die Hilfsschicht (24) durch eine Temperung aufgebrochen wird.

3. Verfahren nach einem der Ansprüche 1 oder 2,
bei dem die Schicht (30) aus mehr als zwei Teilschichten (23, 25, 27, 29) zusammengesetzt wird.

4. Verfahren nach einem der Ansprüche 1 bis 3,
- bei dem auf das Substrat (11) eine Opferschicht (12) aufgebracht wird, die selektiv zum Substrat (11) und zu der Schicht mit reduzierten mechanischen Spannungen (15) ätzbar ist,
- bei dem die Schicht (15) auf der Oberfläche der Opferschicht (12) hergestellt wird,
- bei dem die Schicht (15) strukturiert wird,
- bei dem die Opferschicht (12) durch selektives Ätzen teilweise entfernt wird, so daß die strukturierte Schicht (151) über mindestens eine Stützstelle (121) mit dem Substrat (11) verbunden ist.

5. Verfahren nach Anspruch 4,
bei dem die Schicht (15) so strukturiert wird, daß die Teilschichten (13, 14), die die Schicht (15) bilden, gemeinsame Flanken aufweisen.

## Claims

1. Process for the production of a layer with reduced mechanical stresses,
- in which the layer (30) is made up of at least a first sublayer (23) and a second sublayer (25),
- in which the first sublayer (23) is applied to a substrate (21, 22),
- in which the second sublayer (25) is applied to the first sublayer (23),
- in which the first sublayer (23) and the second sublayer (25) are matched to one another in such a way that the stress gradient of the first sublayer (23) and the stress gradient of the second sublayer (25) substantially compensate one another,
- in which an auxiliary layer (24), which is thinner than the sublayers (23, 25), is produced between two neighbouring sublayers (23, 25),
- in which the first sublayer (23) and the second sublayer (25) are produced from polycrystalline or amorphous silicon,
- in which the first sublayer (23) and the second sublayer (25) are doped by implantation,
- in which the first sublayer (23) and the second sublayer (25) are annealed in a heating step,
- in which the auxiliary layer (24) is formed from SiO₂.

2. Process according to Claim 1, in which the auxiliary layer (24) is broken by heating.

3. Process according to one of Claims 1 and 2, in which the layer (30) is made up of more than two sublayers (23, 25, 27, 29).

4. Process according to one of Claims 1 to 3,
- in which a sacrificial layer (12), which can be etched selectively with respect to the substrate (11) and with respect to the layer with reduced mechanical stresses (15), is applied to the substrate (11),
- in which the layer (15) is produced on the surface of the sacrificial layer (12),
- in which the layer (15) is structured,
- in which the sacrificial layer (12) is partially removed by selective etching, so that the structured layer (151) is connected to the substrate (11) via at least one support point (121).

5. Process according to Claim 4, in which the layer (15) is structured in such a way that the sublayers (13, 14) which form the layer (15) have common side edges.

## Revendications

1. Procédé de fabrication d'une couche à contraintes mécaniques réduites,
- dans lequel la couche (30) est composée d'au moins une première sous-couche (23) et d'une deuxième sous-couche (25),
- dans lequel on dépose la première sous-couche (23) sur un substrat (21, 22),
- dans lequel on dépose la deuxième sous-couche (25) sur la première sous-couche (23),
- dans lequel on adapte la première sous-couche (23) et la deuxième sous-couche (25) l'une à l'autre de manière que le gradient de stress de la première sous-couche (23) et le gradient de stress de la deuxième sous-couche (25) se compensent sensiblement,
- dans lequel on produit entre deux sous-couches (23, 25) voisines une couche (24) auxiliaire qui est plus mince que les sous-couches (23, 25),
- dans lequel on produit la première sous-couche (23) et la deuxième sous-couche (25) en silicium polycristallin ou en silicium amorphe,
- dans lequel on dope par implantation la première sous-couche (23) et la deuxième sous-couche (25),
- dans lequel on recuit complètement la première sous-couche (23) et la deuxième sous-couche (25) dans une étape de recuit,
- dans lequel on forme la couche (24) auxiliaire en SiO₂.

2. Procédé suivant la revendication 1, dans lequel on rompt la sous-couche (24) par un recuit.

3. Procédé suivant l'une des revendications 1 ou 2, dans lequel la couche (30) est composée de plus de deux sous-couches (23, 25, 27, 29).

4. Procédé suivant l'une des revendications 1 à 3,
- dans lequel on dépose sur le substrat (11) une couche (12) sacrifiée qui peut être soumise à une attaque chimique sélective par rapport au substrat (11) et par rapport à la couche à contraintes (15) mécaniques réduites,
- dans lequel on produit la couche (15) à la surface de la couche (12) sacrifiée,
- dans lequel on structure la couche (15),
- dans lequel on enlève partiellement la couche (12) sacrifiée par attaque chimique sélective, si bien que la couche (151) structurée est reliée au substrat (11) par l'intermédiaire d'au moins un point (121) d'appui.

5. Procédé suivant la revendication 4, dans lequel on structure la couche (15) de manière que les sous-couches (13, 14), qui forment la couche (15), aient des flancs communs.
